# EUROPEAN PATENT APPLICATION

(11) **EP 1 507 289 A2**
(43) Date of publication of application: **16.02.2005**
(21) Application number: 04103910.8
(22) Date of filing: 13.08.2004
(51) Int. Cl.: H01L 21/768

(54) **Diffusion barrier for copper lines in integrated circuits**

(30) Priority: 14.08.2003 US 640733
(71) Applicant: TEXAS INSTRUMENTS INCORPORATED, Dallas, TX 75265 (US)
(72) Inventor: Grunow, Stephan, Dallas, Texas 75251 (US); Papa Rao, Satyavolu S., Garland, Texas 75044 (US); Russell, Noel M., Plano, Texas 75025 (US)
(74) Representative: Holt, Michael

(57) **Abstract**

A method for forming improved diffusion barriers for copper lines in integrated circuits is described. A low-k dielectric layer (10) is formed over a semiconductor (5). A trench (15) is formed in the low-k dielectric layer (10) and a TiNSi layer (20) is formed in the trench. An α-Ta layer (30) is formed over the TiNSi layer (20) and copper (40) is subsequently formed in the trench (15) filling the trench (15).

## Description

### FIELD OF THE INVENTION

The invention is generally related to the field of integrated circuits and more specifically to an improved diffusion barrier for copper lines in integrated circuits.

### BACKGROUND OF THE INVENTION

Copper is increasingly being used to form the metal interconnect lines in integrated circuits. Copper forms low resistivity lines that allow high circuit operating frequencies. In addition copper possesses a reduced susceptibility to electromigration failure as compared to the more traditional aluminum or aluminum alloy metal interconnects.

In addition to the use of copper, low dielectric constant (low-k) dielectric material is being used to form the layers above the surface of the semiconductor in which the copper layers are formed. In general copper has a tendency to diffuse into these dielectric layers and barrier layers are used to encapsulate the copper metal interconnect lines formed in the dielectric layers. The diffusion of copper is exacerbated when low-k dielectric layers are used and current methods are often inadequate to prevent the diffusion of copper while maintaining adequate integrated circuit performance. There is therefore a need for an improved diffusion barrier for copper lines in integrated circuits.

### SUMMARY OF THE INVENTION

A method for forming a diffusion barrier for copper lines in integrated circuits is provided The method comprises providing a semiconductor and forming a low-k dielectric layer over the semiconductor. A trench and/or via is formed in the low-k dielectric layer and a diffusion barrier comprising titanium silicon nitride is formed in trench (and/or via) using chemical vapor deposition (CVD). In a first embodiment the diffusion barrier is formed by the decomposition of TDMAT [(CH₃)₂N]₄Ti] within a temperature range of 300°C to 500°C and at a pressure between 0.1 to 50 torr. In a further embodiment the diffusion barrier is formed by the decomposition of [(C₂H₅)₂N]₄Ti and in yet a further embodiment the diffusion barrier is formed by the decomposition of [(CH₃)(C₂H₅)N]₄Ti. The diffusion barrier is heated in a silicon-containing ambient at temperatures between 350°C to 500°C following the CVD deposition. An alpha phase tantalum (α-Ta) layer with a body centered cubic structure is formed over the diffusion barrier and copper is formed over the alpha phase tantalum to fill the trench (and/or via). The α - Ta layer is between 20 - 1000 angstroms thick and has an x-ray diffraction peak using copper K radiation at about 38.5 (2-Theta).

### BRIEF DESCRIPTION OF THE DRAWINGS

In the drawings:
FIGURES 1A -1B are cross-sectional diagrams illustrating an embodiment of the instant invention.
FIGURE 2 is an x-ray diffraction spectra for the α-tantalum of the instant invention.

Common reference numerals are used throughout the figures to represent like or similar features. The figures are not drawn to scale and are merely provided for illustrative purposes.

### DETAILED DESCRIPTION OF THE INVENTION

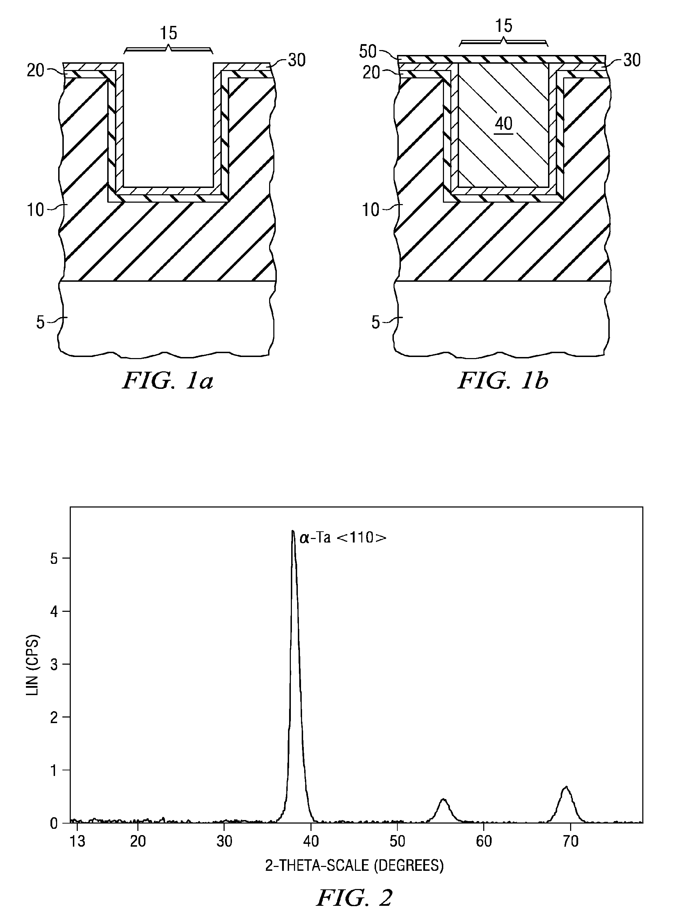

While the following description of the instant invention revolves around FIGURES 1A - 1B, the instant invention can be utilized in any semiconductor device structure. The methodology of the instant invention provides an improved diffusion barrier for copper metal lines in integrated circuits.

Shown in Figure 1(a) is a dielectric layer 10 formed over a semiconductor 5. The semiconductor will comprise electronic devices such as transistors, capacitors, resistors, diodes, inductors, etc. These various devices will be interconnected with copper metal lines to form the integrated circuit. The electronic devices are omitted from the Figures for clarity. Following the formation of the various electronic devices, a number of layers are formed over the semiconductor 5. Any number of layers can be formed over the semiconductor 5 depending on the requirements of the integrated circuit. In Figure 1(a) the dielectric layer 10 is shown over the semiconductor 5. However it should be noted that any number of layers can be formed between the semiconductor and the dielectric layer 10 shown in Figure 1(a) without departing from the scope of the instant invention. In an embodiment of the instant invention the dielectric layer 10 is formed comprising silicon oxide. In a further embodiment of the instant invention low-k dielectric material such as siloxane, silsesquioxanes, xerogels, organosilicate glass (OSG), methylsilsesquioxane (MSQ), organic polymers, and other suitable spin-on-glass material can be use to form the dielectric layer 10. For purposes of this invention a low-k dielectric can be considered to be material possessing a dielectric constant of less than 3.9, which is the dielectric constant of silicon dioxide. A trench 15 is formed in the dielectric layer 10 using standard processing techniques. Such techniques include forming a patterned photoresist layer on the dielectric layer 10, followed by anisotropic etching of the exposed regions of the dielectric layer 10. The trench can be of a single width 15 as shown in Figure 1(a) or it can comprise multiple widths without departing from the scope of the instant invention. In addition the trench can be formed completely in the dielectric layer as shown in Figure 1(a) or it can be formed in a dielectric layer over a copper line. Furthermore the trench can be formed such that the copper formed in the trench will be in electrically contact with underlying copper lines. These features have been omitted from the Figures of the instant disclosure for clarity Also the trench can be formed using either single or dual damascene integration schemes.

Following the formation of the trench 15 in the dielectric layer 10, a conformal diffusion barrier of titanium silicon nitride (TiNSi) 20 is formed in the trench using chemical vapor deposition (CVD). In a first embodiment the TiNSi layer 20 is between 20 and 200 angstroms thick. In a first embodiment the CVD process used to form the TiNSi layer comprises first forming a titanium nitride (TiN) using metal-organic chemical vapor deposition (MOCVD). Preferably the MOCVD process comprises the thermal decomposition of TDMAT, [(CH₃)₂N]₄Ti. TDMAT is a liquid and is preferably introduced into the reactor using a carrier gas, such as He or N₂. The decomposition is preferably achieved within a temperature range of 300°C to 500°C and at a pressure between 0.1 to 50 torr. In an alternate embodiment, C₂H₅ can be used in place of CH₃ so that the precursor would be [(C₂H₅)₂N]₄Ti. In another embodiment, the precursor would preferably be [(CH₃)(C₂H₅)N]₄Ti. Following the formation of the initial TiN layer, the material is exposed to plasma ta approximately 1.5 to 3 W/cm2 plasma density, preferably using a mixture of hydrogen and nitrogen, to densify the TiN layer and to replace carbon species with nitrogen species in the carbon containing TiN layer. The aforementioned steps of initial TiN deposition followed by plasma treatment can be repeated multiple times to form multi-layered plasma-treated TiN layers. In a preferred embodiment of the instant invention, two plasma-treated TiN layers are formed with thicknesses of between 20-40 angstroms each. Following the final plasma treatment, a heating step is performed in a silane, disilane, or any other ambient that can produce silicon in the film. Preferably, this step is performed at approximately 350°C to 500°C at 0.1 to 50 torr for approximately 5 to 240 seconds. This results in the formation of the TiNSi layer 20. The formation of TiNSi using CVD offers distinct advantages over previously used materials. TiNSi exhibits superior diffusion-barrier properties over traditional barrier materials such as tantalum, tantalum nitride, titanium nitride, tantalum silicon, titanium nitride, tungsten, or tungsten nitride. Additionally, when deposited via physical-vapor-deposition (PVD), the above materials are more prone to result in dielectric voiding when low-dielectric-constant (low-k) material is used to form the underlying dielectric layer 10. Low-k dielectric material is usually less dense/and or more porous than higher dielectric constant material such as silicon dioxide, phosphosilicate-glass (PSG), boron doped PSG (BPSG), or tetraethylorthosilicate (TEOS) and is more susceptible to the creation of voids.

Discontinuities in the barrier layer can result in reactions between the porous low-k dielectric and the copper-electrolyte solution during subsequent electro-chemical disposition (ECD) of copper. The use of a thin and conformal CVD TiNSi is effective in eliminating this dielectric-voiding mechanism. Further, CVD TiNSi offers advantages over CVD TaSiN by providing good diffusion-barrier properties while exhibiting low resistivity as compared to CVD TaSiN films. Therefore the above list of other materials would be less suitable for use in forming barrier layers on low-k dielectric material.

Following the formation of the TiNSi layer 20, an alpha phase tantalum (α-Ta) layer 30 with a body centered cubic structure is formed over the TiNSi layer 20. The α-Ta layer on top of CVD TiNSi is critical to improve the wettability of the barrier-to-copper interface and, hence, reliability. The α-Ta layer 30 is between 20 - 1000 angstroms thick and can be formed using any number of techniques such as physical vapor deposition (PVD), chemical vapor deposition (CVD), and atomic layer deposition (ALD). In an embodiment where PVD is used to form the α-Ta layer 30, 100-1000 Watts of DC power is applied to a Ta target to initiate the plasma in a PVD chamber with argon gas. Following the initiation of the plasma, between 5kW and 30kW of power is applied to the Ta target in the chamber. The resulting α-Ta layer produced has low resistivity of greater than 18 micro-ohm-centimeter (µΩ-cm) and more specifically around 25 µΩ-cm. The α-Ta of the instant invention has an x-ray (110) diffraction peak at about 38.5 (2-Theta) as shown in Figure 2. The diffraction peak shown in Figure 2 is measured by depositing a 400A layer of α-Ta on a layer of TiNSi. The x-ray diffraction peak shown in Figure 2 was obtained using a point copper K_{α1} and K_{α2} source at 50KeV and 40mA with a two-dimension detector.

Following the formation of the α-Ta layer 30, copper or a copper alloy 40 is used to fill the trench or to deposit a conductive seed layer for subsequent trench fill using a number of methods including, but not limited to, electro-chemical deposition. A typical copper process comprises depositing a thin and conductive seed layer, filling the trench (and/or via) with copper, and removing any excess copper using chemical mechanical polishing (CMP). Following the formation of the copper or copper alloy interconnect structure 40, a capping layer 50 can be formed over the copper interconnect structure 40. The capping layer can comprise silicon nitride or any other suitable material. Following the formation of the capping layer, other structures can be formed to complete the fabrication of the integrated circuit.

While this invention has been described with reference to illustrative embodiments, this description is not intended to be construed in a limiting sense. Various modifications and combinations of the illustrative embodiments, as well as other embodiments of the invention will be apparent to persons skilled in the art upon reference to the description. It is therefore intended that the appended claims encompass any such modifications or embodiments.

## Claims

1. A method for forming a diffusion barrier for copper lines, comprising:
providing a semiconductor;
forming a dielectric layer over said semiconductor;
forming a trench in said dielectric layer;
forming a diffusion barrier comprising titanium silicon nitride in said trench using chemical vapor deposition (CVD); and
forming an alpha phase tantalum (α-Ta) layer with a body centered cubic structure over said diffusion barrier.

2. The method of claim 1 for forming an integrated circuit copper line, further comprising forming copper in said trench over said alpha phase tantalum (α-Ta) layer.

3. The method of either claim 1 or claim 2, wherein said diffusion barrier is formed by the decomposition of TDMAT [(CH₃)₂N]₄Ti] within a temperature range of 300°C to 500°C and at a pressure between 0.1 to 50 torr.

4. The method of any of either claim 1 or claim 2, wherein said diffusion barrier is formed by the decomposition of [(C₂H₅)₂N]₄Ti.

5. The method of either claim 1 or claim 2, wherein said diffusion barrier is formed by the decomposition of [(CH₃) (C₂H₅)N]₄Ti.

6. The method of any of claims 1 - 5, further comprising heating said diffusion barrier in a silicon containing ambient at temperatures between 350°C to 500°C.

7. The method of any of claim 6, further comprising performing said heating at 0.1 to 50 torr for approximately 5 to 240 seconds.

8. The method of any of claims 1 - 7, wherein said alpha phase tantalum (α-Ta) layer is between 20 -1000 angstroms thick.

9. The method of any of claims 1 - 8, wherein said alpha phase tantalum (α-Ta) layer has an x-ray diffraction peak at about 38.5 (2-Theta).

10. The method of any of claims 1 - 9, wherein said dielectric layer is formed as a low-k dielectric layer.
